# EUROPEAN PATENT APPLICATION

(11) **EP 3 336 556 A1**
(43) Date of publication of application: **20.06.2018**
(21) Application number: 16832584.3
(22) Date of filing: 27.05.2016
(51) Int. Cl.: G01N 35/08, B01D 15/16, B01J 19/00, B81B 1/00, G01N 37/00

(54) **FLOW PATH STRUCTURE, MEASUREMENT UNIT, METHOD FOR MEASURING LIQUID TO BE MEASURED, AND DEVICE FOR MEASURING LIQUID TO BE MEASURED**

(30) Priority: 05.08.2015 JP 2015155537
(71) Applicant: Alps Electric Co., Ltd., Tokyo 145-8501 (JP)
(72) Inventor: TAGUCHI, Yoshihiro, Tokyo 145-8501 (JP); MINAGUCHI, Hiroyoshi, Kyoto-shi Kyoto 602-8155 (JP); HOSOYA, Ken, Kyoto 612-8031 (JP)
(74) Representative: Maiwald Patent- und Rechtsanwaltsgesellschaft mbH
(86) International application number: PCT/JP2016/065669
(87) International publication number: WO 2017/022305

(57) **Abstract**

As a channel structure capable of attaining reduction in size and improvement in portability of a device having incorporated therein the channel structure, there is provided a channel structure 1 including a liquid storage 10 having a liquid container portion 11 capable of storing liquid and an outlet portion 12, a separation-element housing 20 having arranged therein a separation element between two open ends 21 and 22 thereof, a supply channel 30 connected to the outlet portion 12 of the liquid storage 10 and the one open end 21 of the separation-element housing 20 and causing the liquid storage 10 and the separation-element housing 20 to communicate with one another, and a discharge channel 40 connected to the other open end 22 of the separation-element housing 20. The supply channel 30 includes a liquid-storage-side channel 31 connected to the outlet portion 12 of the liquid storage 10, a separation-element-side channel 32 connected to the separation-element housing 20, and an injection portion 33 located between the liquid-storage-side channel 31 and the separation-element-side channel 32 and being capable of introducing liquid to be measured into the supply channel 30. The liquid storage 10 includes a pressure transmission portion 13 capable of transmitting an external force applied to the channel structure 1, as a variation in a pressure in the liquid storage 10, and is capable of causing liquid stored in the liquid storage 10 to flow out from the outlet portion 12 to the supply channel 30 on the basis of the variation in the pressure in the liquid storage 10.

## Description

### Technical Field

The present invention relates to a channel structure used in a measurement device for liquid to be measured capable of being used for POCT, a measurement unit including the channel structure, a method of measuring liquid to be measured using the measurement unit, and a measurement device for liquid to be measured including the above-described measurement unit.

### Background Art

In recent years, point-of-care testing (POCT) representing an easy and quick inspection etc. to be performed by a medical staff at the site of diagnosis and nursing is becoming popular.

Regarding POCT, PTL 1 describes a porous silica column containing porous silica as a main component. The porous silica column includes a first porous silica portion having a first characteristic and a first mean pore diameter, and a second porous silica portion having a second characteristic different from the first characteristic, and a second mean pore diameter different from the first mean pore diameter. Fig. 3 of PTL 1 illustrates a HPLC (high-performance liquid chromatography) device using the above-described porous silica column.

Regarding a micro-channel chip, PTL 2 describes a channel chip formed by bonding a first base member and a second base member to one another, and having a channel and a processing vessel connected to the channel between the first base member and the second base member. The processing vessel has arranged therein a plate-shaped porous body with a triangular shape in a plan view. With the channel chip, liquid leakage and dead volume can be decreased as compared with related art, and therefore the channel chip described in PTL 2 is suitable for a tool for POCT.

### Citation List

### Patent Literature

PTL 1: International Publication No. 2008/023534
PTL 2: Japanese Unexamined Patent Application Publication No. 2014-38018

### Summary of Invention

### Technical Problem

When a measurement is performed for obtaining information about the composition of liquid to be measured by using a channel chip (channel structure) as described in PTL 2, a device having incorporated therein the channel structure and causing liquid to be circulated in a separation element in the channel structure is required. To realize POCT, such a device is preferably small.

It is an object of the present invention to provide a channel structure easily responding to reduction in size of a measurement device having incorporated therein a channel structure. It is also an object of the present invention to provide a measurement unit including the channel structure, a method of measuring liquid to be measured using the measurement unit, and a measurement device for liquid to be measured including the above-described measurement unit.

### Solution to Problem

As a result that the inventors of the present invention have studied to address the aforementioned problems, the inventors have obtained new findings that the measurement device can be used in a dry environment and the measurement device can be reduced in size if a channel structure can store liquid to be circulated in a separation element of the channel structure, and if the measurement device having incorporated therein the channel structure does not directly contact the liquid stored in the channel structure when the liquid is circulated in the separation element.

According to an aspect of the present invention made on the basis of the aforementioned findings, there is provided a channel structure including a liquid storage having a liquid container portion capable of storing liquid and an outlet portion, a separation-element housing having arranged therein a separation element between two open ends thereof, a supply channel connected to the outlet portion of the liquid storage and the one open end of the separation-element housing and causing the liquid storage and the separation-element housing to communicate with one another, and a discharge channel connected to the other open end of the separation-element housing. The supply channel includes a liquid-storage-side channel connected to the outlet portion of the liquid storage, a separation-element-side channel connected to the separation-element housing, and an injection portion located between the liquid-storage-side channel and the separation-element-side channel and being capable of introducing liquid to be measured into the supply channel. The liquid storage includes a pressure transmission portion capable of transmitting an external force applied to the channel structure, as a variation in a pressure in the liquid storage, and is capable of causing liquid stored in the liquid storage to flow out from the outlet portion to the supply channel on the basis of the variation in the pressure in the liquid storage.

Since the channel structure has the above-described configuration, the liquid stored in the liquid storage can be circulated to the separation element without contacting a member other than the members configuring the channel structure.

The channel structure may be formed of a bonded body of a plurality of plate-shaped base members. With such a configuration, the channel structure having various structure parts can be efficiently obtained.

The pressure transmission portion may be a tubular body communicating with the inside of the liquid storage and the outside of the channel structure, and the pressure in the liquid storage can be increased by a pressure of a fluid to be supplied from outside the channel structure into the tubular body. With such a configuration, if a device having incorporated therein the channel structure has a gas supply system, the liquid in the liquid storage can be supplied into the separation element.

The pressure transmission portion may have a direct-acting structure, and the pressure in the liquid storage can be increased by a force applied from outside the channel structure to the direct-acting structure. With such a configuration, if a device having incorporated therein the channel structure has a driving system for moving the direct-acting mechanism, the liquid in the liquid storage can be supplied into the separation element.

The specific configuration of the separation element is not particularly limited. The separation element may be a separation column or may be an electric migration element.

To easily supply the liquid into the liquid container portion of the liquid storage, an input portion capable of inputting liquid into the liquid container portion may be provided.

To supply the liquid into the liquid container portion of the liquid storage and to cause the liquid to easily flow out from the liquid container portion, a vent capable of discharging gas in the liquid container portion of the liquid storage may be provided.

To more properly mix liquid to be measured supplied from the injection portion with the liquid from the liquid storage, a porous body promoting mixing of the liquid to be measured with the liquid from the liquid storage is preferably arranged in the injection portion. The porous body arranged in the injection portion may have a function of promoting separation of the liquid to be measured in cooperation with the separation element.

To increase separation performance of the separation element, a rectifying portion arranged at the liquid-storage-side channel and decreasing a variation in a flow rate of liquid flowing in the injection portion is preferably further provided.

A plurality of the liquid storages and a plurality of the liquid-storage-side channels connected to the plurality of liquid storages may be further provided. The supply channel may include a convergence portion arranged between outlet portions of the plurality of liquid storages and the separation-element-side channel, converging the plurality of liquid-storage-side channels, and causing the plurality of liquid storages to communicate with the separation-element-side channel. With such a configuration, the type of the composition of liquid to be supplied to the separation element can be plural types.

To more properly mix liquid from the plurality of liquid storages, a porous body promoting mixing of the liquid from the plurality of liquid storages is preferably arranged in the convergence portion. The porous body arranged in the convergence portion may have a function of promoting separation of the liquid to be measured in cooperation with the separation element.

To more properly mix the liquid from the plurality of liquid storages and to increase separation performance of a separation element, an individual rectifying portion arranged between the outlet portion and the convergence portion and decreasing a variation in a flow rate of liquid flowing in the convergence portion is preferably provided.

To simplify the structure, the injection portion is preferably integrally provided with the convergence portion.

A waste-liquid storage connected to an open end of the discharge channel opposite to an open end of the discharge channel connected to the separation-element housing, and storing liquid passing through the separation element may be further provided. In this case, a measurement device having incorporated therein the channel structure does not have to contact the liquid required for analysis, and the measurement device can be used in a dry environment. The waste-liquid storage preferably has a vent discharging gas in the waste-liquid storage.

When the channel structure according to the present invention is formed of a bonded body of a plurality of plate-shaped base members, at least one of the plurality of plate-shaped base members forming the bonded body may transmit measurement light in a wavelength range emitted for measuring the liquid to be measured, and the discharge channel preferably includes a channel portion extending in a thickness direction of the bonded body. With such a configuration, even if the cross-sectional area of the channel is small, measurement sensitivity can be increased.

A distance between a portion of the liquid container portion of the liquid storage being the closest to one of principal surfaces of the bonded body and the one of the principal surfaces of the bonded body is preferably smaller than a distance between a portion of the separation-element housing being the closest to the one of the principal surfaces of the bonded body and the one of the principal surfaces of the bonded body. With such a configuration, gas babbles hardly remain in the separation element and the separation performance is hardly decreased when the channel structure is used.

The plate-shaped base members are preferably three or more plate-shaped base members. With such a configuration, the degree of freedom of design in the channel structure can be increased.

When the plate-shaped base members are three or more plate-shaped base members, the liquid storage is preferably formed by removing a portion of at least two of the plate-shaped base members, and the separation-element housing is preferably formed by removing a portion of at least two of the plate-shaped base members. The at least two of the plate-shaped members forming the liquid storage are preferably different from the at least two of the plate-shaped members forming the separation-element housing. With such a configuration, gas babbles hardly remain in the separation element and the separation performance is hardly decreased when the channel structure is used.

According to another aspect of the present invention, there is provided a measurement unit including the above-described channel structure according to the present invention; and liquid stored in the liquid container portion of the channel structure. Since the measurement unit according to the present invention includes the liquid required for measurement in advance, the measurement device having incorporated therein the channel structure does not have to supply the liquid required for measurement to the channel structure.

According to still another aspect of the present invention, there is provided a method of measuring liquid to be measured including inputting liquid to be measured to the injection portion of the measurement unit according to the present invention; applying an external force to the pressure transmission portion, supplying liquid solution in the liquid container portion into the supply channel, and causing liquid containing the liquid to be measured to pass through the inside of the separation element; and measuring liquid containing the liquid to be measured passing through the separation element, and obtaining information on a composition of the liquid to be measured.

In the method of measuring liquid to be measured, at least one of the plurality of plate-shaped base members forming the bonded body may transmit measurement light in a wavelength range emitted for measuring the liquid to be measured, and the information on the composition of the liquid to be measured may be obtained by irradiating liquid containing the liquid to be measured passing through the separation element and located in the discharge channel, with the measurement light.

In the method of measuring liquid to be measured, the separation element may be a separation column, and a pressure of liquid to be supplied to the separation column may be 1 MPa or lower. Since the channel structure according to the present invention can be increased in analysis performance while reduced in size, the pressure of the liquid to be supplied to the separation column can be decreased.

According to yet another aspect of the present invention, there is provided a measurement device for liquid to be measured including the measurement unit according to the present invention. Such a measurement device can easily respond to reduced in size.

### Advantageous Effects of Invention

With the present invention, a channel structure easily applicable to a measurement device having incorporated therein the channel structure can be provided. Also, with the present invention, a measurement unit including the above-described channel structure, a method of measuring liquid to be measured using the above-described measurement unit, and a measurement device for liquid to be measured including the above-described measurement unit can be provided.

### Brief Description of Drawings

[Fig. 1] Fig. 1 is a perspective view of a channel structure according to a first embodiment of the present invention.
[Fig. 2] Fig. 2 is a perspective view in a state in which two plate-shaped members forming the channel structure according to the first embodiment of the present invention are separated from one another.
[Fig. 3] Fig. 3 is a perspective view illustrating only a channel part of the channel structure according to the first embodiment of the present invention.
[Fig. 4] Fig. 4 is a perspective view in a state in which two plate-shaped members forming a channel structure according to a modification of the first embodiment of the present invention are separated from one another.
[Fig. 5] Fig. 5 is a perspective view of a channel structure according to a second embodiment of the present invention.
[Fig. 6] Fig. 6 is a perspective view in a state in which four plate-shaped members forming the channel structure according to the second embodiment of the present invention are separated from one another.
[Fig. 7] Fig. 7 is a cross-sectional view taken along line A-A in Fig. 5.
[Fig. 8] Fig. 8 is a cross-sectional view taken along line B-B in Fig. 5.
[Fig. 9] Fig. 9 is a perspective view in a state in which four plate-shaped members forming a channel structure according to a third embodiment of the present invention are separated from one another.
[Fig. 10] Fig. 10 is a cross-sectional view taken along line C-C in Fig. 9.
[Fig. 11] Fig. 11 is a cross-sectional view taken along line D-D in Fig. 9.
[Fig. 12] Fig. 12 is a perspective view of a channel structure according to a fourth embodiment of the present invention.
[Fig. 13] Fig. 13 is a perspective view in a state in which two plate-shaped members forming the channel structure according to the fourth embodiment of the present invention are separated from one another.
[Fig. 14] Fig. 14 is a perspective view illustrating only a channel part of the channel structure according to the fourth embodiment of the present invention.
[Fig. 15] Fig. 15 is a perspective view illustrating only a channel part of a channel structure according to a modification (first modification) of the fourth embodiment of the present invention.
[Fig. 16] Fig. 16 is a perspective view illustrating only a channel part of a channel structure according to another modification (second modification) of the fourth embodiment of the present invention.
[Fig. 17] Fig. 17 is a perspective view in a state in which two plate-shaped members forming the channel structure according to the second modification of the fourth embodiment of the present invention are separated from one another.
[Fig. 18] Fig. 18 is a perspective view illustrating only a channel part of a channel structure according to still another modification (third modification) of the fourth embodiment of the present invention.
[Fig. 19] Fig. 19 is a perspective view in a state in which two plate-shaped members forming a channel structure according to yet another modification (fourth modification) of the fourth embodiment of the present invention are separated from one another.
[Fig. 20] Fig. 20 is a perspective view of a channel structure according to a further modification (fifth modification) of the fourth embodiment of the present invention.
[Fig. 21] Fig. 21 is a perspective view in a state in which three plate-shaped members forming the channel structure according to the fifth modification of the fourth embodiment of the present invention are separated from one another.
[Fig. 22] Fig. 22 is a perspective view illustrating only a channel part of the channel structure according to the fifth modification of the fourth embodiment of the present invention.

### Description of Embodiments

A channel structure, a measurement unit, a method of measuring liquid to be measured, and a measurement device for liquid to be measured according to embodiments of the present invention are described below with reference to the drawings. In the following description, the same reference signs are applied to the same members, and the description on a member already described is appropriately omitted.

### First Embodiment

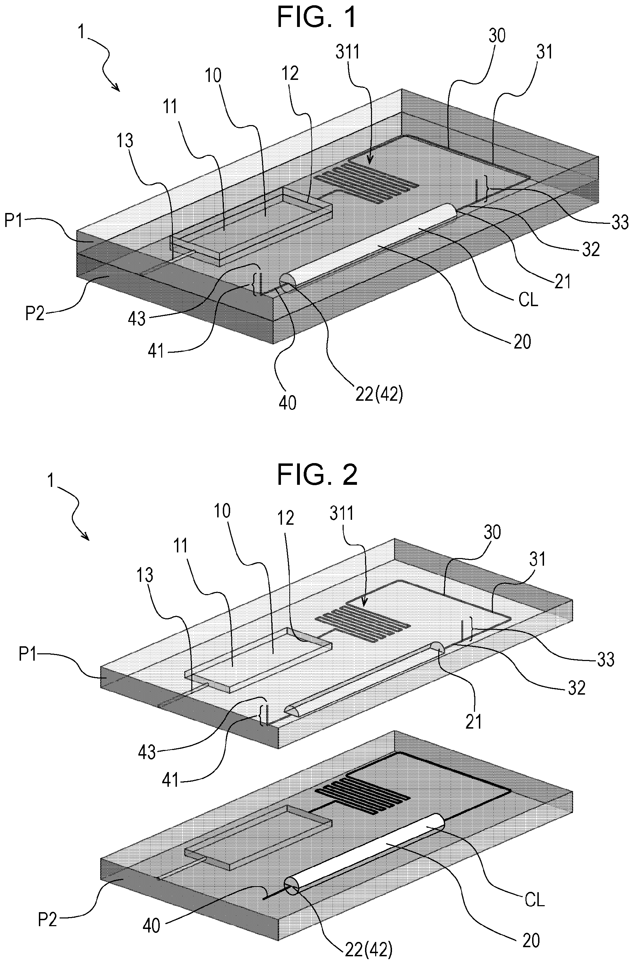

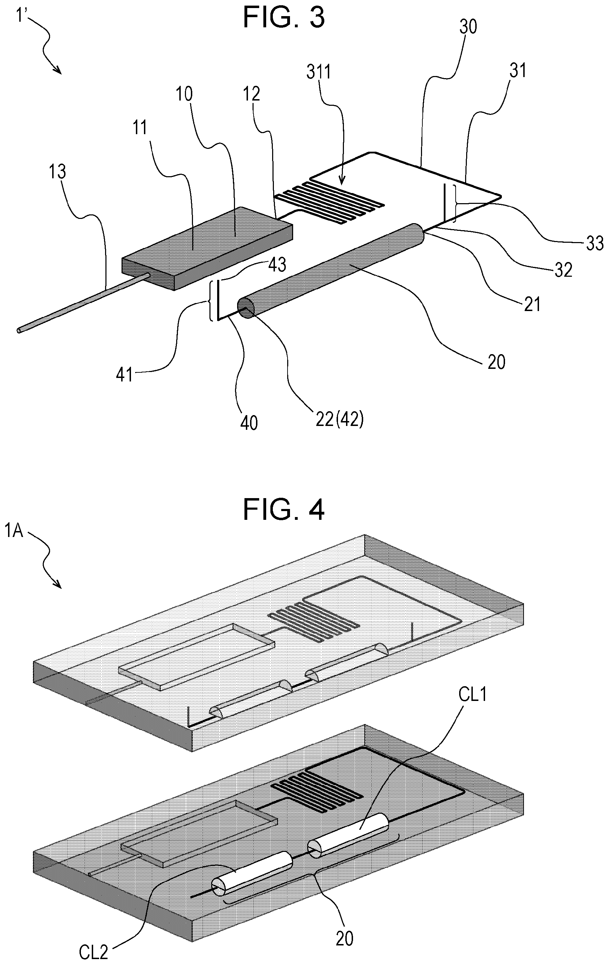

Fig. 1 is a perspective view of a channel structure according to a first embodiment of the present invention. Fig. 2 is a perspective view in a state in which two plate-shaped members forming the channel structure according to the first embodiment of the present invention are separated from one another. Fig. 3 is a perspective view illustrating only a channel part of the channel structure according to the first embodiment of the present invention.

A channel structure 1 according to the first embodiment illustrated in Figs. 1 to 3 is a bonded body of two plate-shaped members P1 and P2 made of transparent materials. The transparent materials may be glass, an acrylic-based resin material, a cycloolefin-based resin material, or a polyester-based resin material. In viewpoints of ease of manufacturing and a wide transparent wavelength range, it is preferable that at least one of the two plate-shaped members P1 and P2 is made of a cycloolefin-based resin material, and it is more preferable that both the two plate-shaped members P1 and P2 are made of a cycloolefin-based resin material.

The channel structure 1 according to the first embodiment includes a liquid storage 10 having a liquid container portion 11 capable of storing liquid and an outlet portion 12. The channel structure 1 includes a separation-element housing 20 having arranged therein a separation element (in this embodiment, separation column CL) between two open ends 21 and 22 thereof. The channel structure 1 includes a supply channel 30 connected to the outlet portion 12 of the liquid storage 10 and the one open end 21 of the separation-element housing 20, and causing the liquid storage 10 and the separation-element housing 20 to communicate with one another. The channel structure 1 includes a discharge channel 40 connected to the other open end 22 of the separation-element housing 20.

The supply channel 30 includes a liquid-storage-side channel 31 connected to the outlet portion 12 of the liquid storage 10, a separation-element-side channel 32 connected to the separation-element housing 20, and an injection portion 33 located between the liquid-storage-side channel 31 and the separation-element-side channel 32 and being capable of introducing liquid to be measured into the supply channel 30. In the channel structure 1 according to an embodiment of the present invention, a connection portion among the liquid-storage-side channel 31, the separation-element-side channel 32, and the injection portion 33 is formed by a T-shaped branch.

The liquid storage 10 includes a pressure transmission portion 13 capable of transmitting an external force applied to the channel structure 1, as a variation in the pressure in the liquid storage 10. With the pressure transmission portion 13, liquid stored in the liquid storage 10 can flow out from the outlet portion 12 to the supply channel 30 on the basis of the variation in the pressure in the liquid storage 10. By applying an external force to the pressure transmission portion 13, a measurement device (not illustrated) having incorporated therein the channel structure 1 can cause the liquid stored in the liquid storage 10 to flow out to the supply channel 30, and further can supply the liquid into the separation element (separation column CL). Accordingly, the measurement device can allow the separation element (separation column CL) to function without contacting the liquid stored in the channel structure 1.

In the channel structure 1 according to this embodiment, the pressure transmission portion 13 is a tubular body communicating with the inside of the liquid storage 10 and the outside of the channel structure 1. Also, the pressure of the inside of the liquid storage 10 can be increased by the pressure of a fluid to be supplied from outside the channel structure 1 into the tubular body forming the pressure transmission portion 13. With such a configuration, if the measurement device having incorporated therein the channel structure 1 has a gas supply system (for example, compressed-air system), the liquid in the liquid container portion 11 of the liquid storage 10 can be supplied into the separation element (separation column CL) arranged in the separation-element housing 20.

When the channel structure 1 according to this embodiment is used, the liquid container portion 11 of the channel structure 1 stores a developing solution, and the channel structure 1 and the developing solution are incorporated as a measurement unit in the measurement device. To easily supply the developing solution to the liquid container portion 11, an input portion (not illustrated) capable of inputting liquid into the liquid container portion 11 may be provided. The input portion may be formed of, for example, a through hole so that one open end thereof is connected to the liquid container portion 11 and the other open end thereof is provided at a principal surface of the plate-shaped member P2 at the lower side in Fig. 1. When the channel structure 1 according to this embodiment is used, the input portion may be closed by a certain method so as to close the open end of the input portion at the principal surface of the plate-shaped member P2 at the lower side in Fig. 1.

To supply the liquid into the liquid container portion 11 of the liquid storage 10 and to cause the liquid to easily flow out from the liquid container portion 11, a vent (not illustrated) capable of discharging gas in the liquid container portion 11 of the liquid storage 10 may be provided. The vent may be formed of, for example, a through hole so that one open end thereof is connected to the liquid container portion 11 and the other open end thereof is provided at a principal surface of the plate-shaped member P1 at the upper side in Fig. 1. When the channel structure 1 according to this embodiment is used, the vent may be closed by a certain method so as to close the open end of the vent at the principal surface of the plate-shaped member P1 at the upper side in Fig. 1.

To more properly mix the liquid to be measured supplied from the injection portion 33 with the liquid from the liquid storage 10, a porous body promoting mixing of the liquid to be measured with the liquid from the liquid storage 10 is preferably arranged in the junction portion of the injection portion 33 with respect to the liquid-storage-side channel 31 and the separation-element-side channel 32.

The porous body arranged in the injection portion 33 is preferably made of a silica monolith. The silica monolith can properly mix the liquid supplied thereinto. If the shape of the silica monolith is properly set, the liquid flowing out to the separation-element-side channel 32 can be liquid in which the liquid flowing in from the liquid-storage-side channel 31 is completely mixed with the liquid supplied to the injection portion 33.

The porous body arranged in the injection portion 33 more preferably has a function of promoting separation of the liquid to be measured in cooperation with the separation element (in this embodiment, separation column CL) housed in the separation-element housing 20. The porous body arranged in the injection portion 33 may have a function considered as pre-processing in relation to the separation element housed in the separation-element housing 20; or the porous body arranged in the injection portion 33 may have a function of a separation element and may configure a separation element having one function in cooperation with the separation element (separation column CL) housed in the separation-element housing 20. This point will be further described in a third embodiment.

In general, regarding the separation element (separation column CL) using the developing solution, it is important to properly control the flow velocity of the developing solution to increase separation performance. Owing to this, a rectifying portion 311 reducing a variation in the flow rate of the liquid flowing in the injection portion 33 is preferably arranged at the liquid-storage-side channel 31 to increase the separation performance of the separation element (separation column CL). The specific shape of the rectifying portion 311 is appropriately set depending on the purpose of use. In the channel structure 1 according to this embodiment, the rectifying portion 311 is formed of a meandering channel.

One open end 42 of the discharge channel 40 of the channel structure 1 is connected to the other open end 22 of the separation-element housing 20, and the other open end 43 of the discharge channel 40 is an opening at an exposed principal surface of the plate-shaped member P1. Hence, the liquid supplied from the liquid storage 10 is discharged outside the channel structure 1 from the other open end 43 of the discharge channel 40.

At least one of a plurality of base members forming the channel structure 1 (in the case of the channel structure 1 according to this embodiment, two plate-shaped base members P1 and P2) preferably transmits measurement light in a wavelength range (for example, 400 nm) emitted for measuring the liquid to be measured, and the discharge channel 40 preferably has a channel portion (measurement channel portion) 41 formed of a bonded body and extending in a thickness direction of the channel structure 1. With such a configuration, even if the cross-sectional area of the channel is small, measurement sensitivity can be increased.

For a non-limiting example, in the channel structure 1 according to this embodiment, the plate-shaped members P1 and P2 have rectangular shapes in a plan view (the shapes in a view in the thickness direction) with dimensions of several centimeters by several centimeters, and the channel has a cross-sectional area of 0.01 mm2 or smaller. Hence, even when measurement light is emitted in a direction not along a flow direction of the discharge channel 40 (typically, a direction orthogonal to the flow direction), it is difficult to increase the measurement sensitivity at irradiation with the measurement light. Owing to this, the discharge channel 40 of the channel structure 1 according to this embodiment has the measurement channel portion 41. The thickness of the channel structure 1 is several millimeters as a non-limiting example. When the measurement light is emitted in the thickness direction of the channel structure 1, the measurement light is emitted in the direction along the flow direction of the channel of the measurement channel portion 41. Accordingly, the volume of the measurement region can be increased, and the measurement sensitivity can be increased.

Fig. 3 illustrates a channel part 1' of the channel structure 1 according to the first embodiment.

### Modification of First Embodiment

Fig. 4 is a perspective view in a state in which two plate-shaped members forming a channel structure according to a modification of the first embodiment of the present invention are separated from one another. A channel structure 1A according to this modification differs from the channel structure 1 according to the first embodiment for the structure of a separation-element housing 20. The separation-element housing 20 of the channel structure 1A can receive two independent separation elements (in this example, first separation column CL1, second separation column CL2). As described above, the separation-element housing 20 can have various shapes depending on the purpose of measurement.

A specific example of using two types of separation columns may be a case where liquid to be measured is blood and a specific analyte is HbA1c. In this case, a negative-ion modified silica monolith can be used as the first separation column CL1, and a positive-ion modified silica monolith can be used as the second separation column CL2.

### Second Embodiment

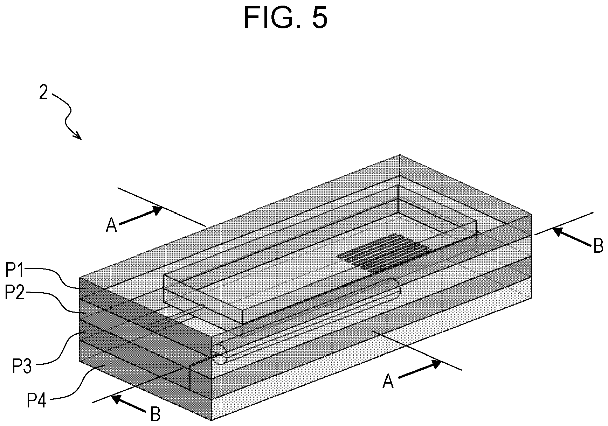

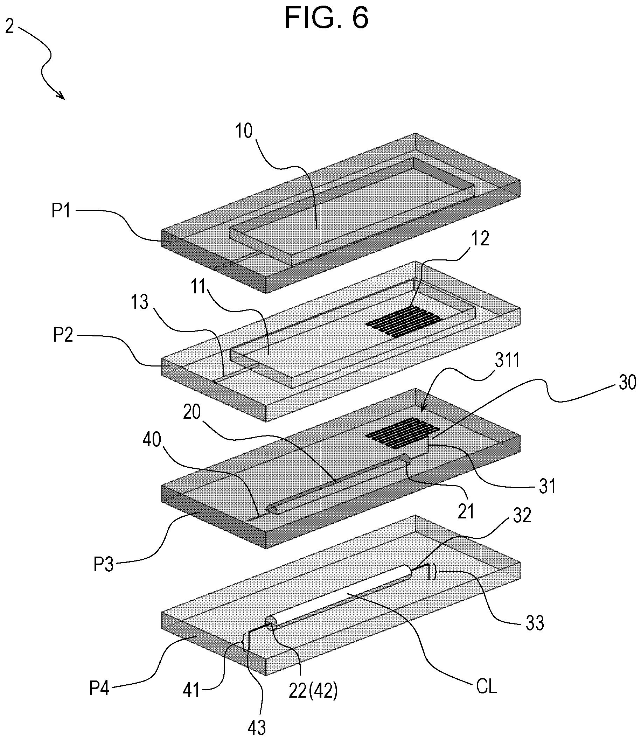

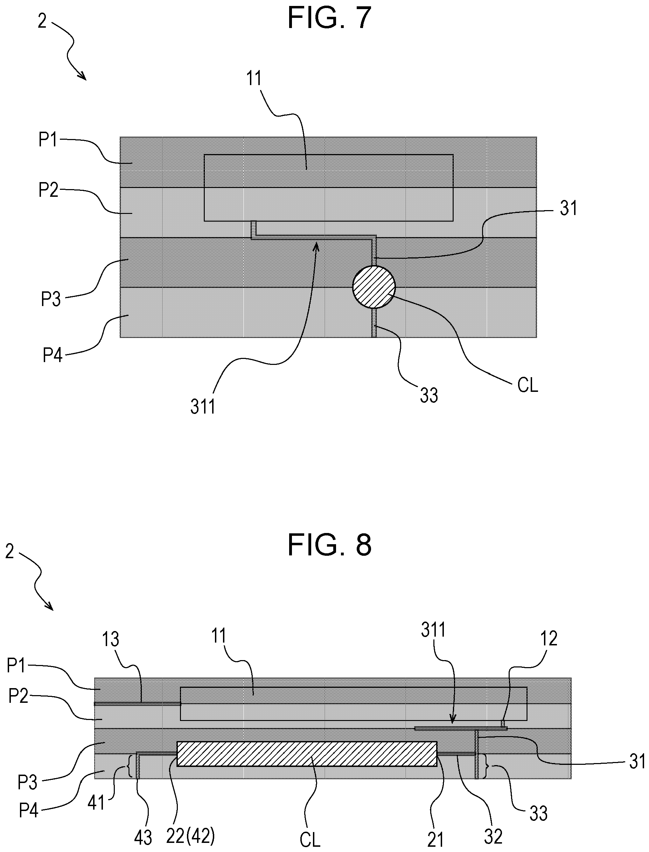

Fig. 5 is a perspective view of a channel structure according to a second embodiment of the present invention. Fig. 6 is a perspective view in a state in which four plate-shaped members forming the channel structure according to the second embodiment of the present invention are separated from one another. Fig. 7 is a cross-sectional view taken along line A-A in Fig. 5. Fig. 8 is a cross-sectional view taken along line B-B in Fig. 5.

A channel structure 2 according to the second embodiment illustrated in Figs. 5 to 8 differs from the channel structure 1 according to the first embodiment for the number of the plate-shaped members forming the channel structure. To be more specific, the channel structure 1 according to the first embodiment is formed of the bonded body of the two plate-shaped members P1 and P2, and the channel structure 2 according to the second embodiment is formed of a bonded body of four plate-shaped members P1, P2, P3, and P4.

A liquid storage 10 is defined by grooves provided at the two plate-shaped members P1 and P2. A separation-element housing 20 is defined by grooves provided at the two plate-shaped members P3 and P4. Hence, as illustrated in the cross-sectional view of Figs. 7 and 8, the entirety of the liquid storage 10 is located above the separation-element housing 20 (at the plate-shaped member P1 side). Hence, in the measurement unit in which liquid is properly input to the channel structure 2, gas hardly enters a separation element (in this embodiment, column CL) in the separation-element housing 20. Therefore, a decrease in measurement accuracy caused by gas bubbles unlikely occurs.

Also, as it is found from the cross-sectional views of Figs. 7 and 8, a liquid container portion 11 of the liquid storage 10 has a region overlapping with the separation-element housing 20 in a plan view. It is not easy to realize such a structure in the channel structure 1 according to the first embodiment formed of the bonded body of the two plate-shaped members P1 and P2. Hence, with the channel structure 2 according to the second embodiment, the volume of the liquid container portion 11 can be more easily increased and the area in a plan view can be more easily decreased, as compared with the channel structure 1 according to the first embodiment.

In the channel structure 2 according to the second embodiment, a supply channel 30 is defined by grooves and through holes provided at the three plate-shaped members P2, P3, and P4. Hence the liquid container portion 11 of the liquid storage 10 also has a region overlapping with the supply channel 30 in a plan view. Accordingly, with the channel structure 2 according to the second embodiment, the structure of the supply channel 30 can be easily made complex as compared with the channel structure 1 according to the first embodiment. In many cases, making the structure of the supply channel 30 complex represents making the supply channel 30 have multiple functions.

### Third Embodiment

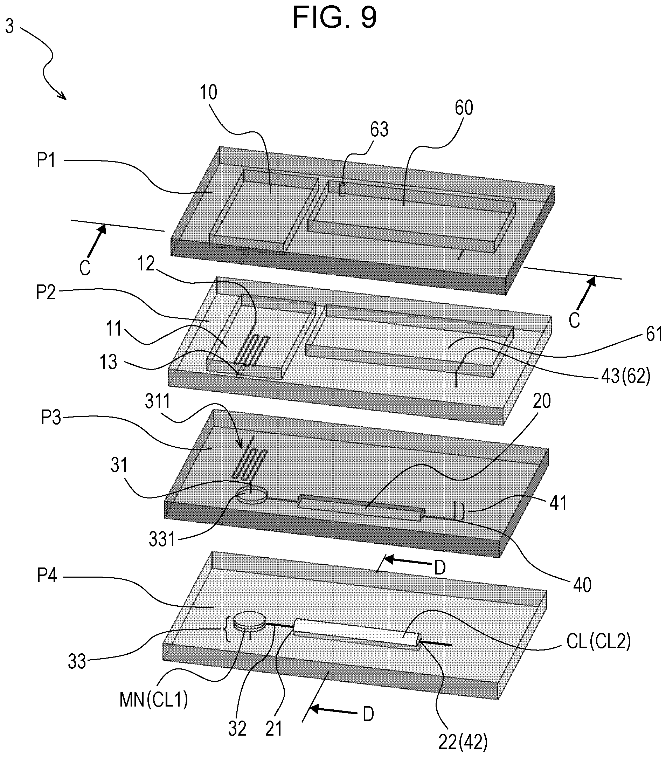

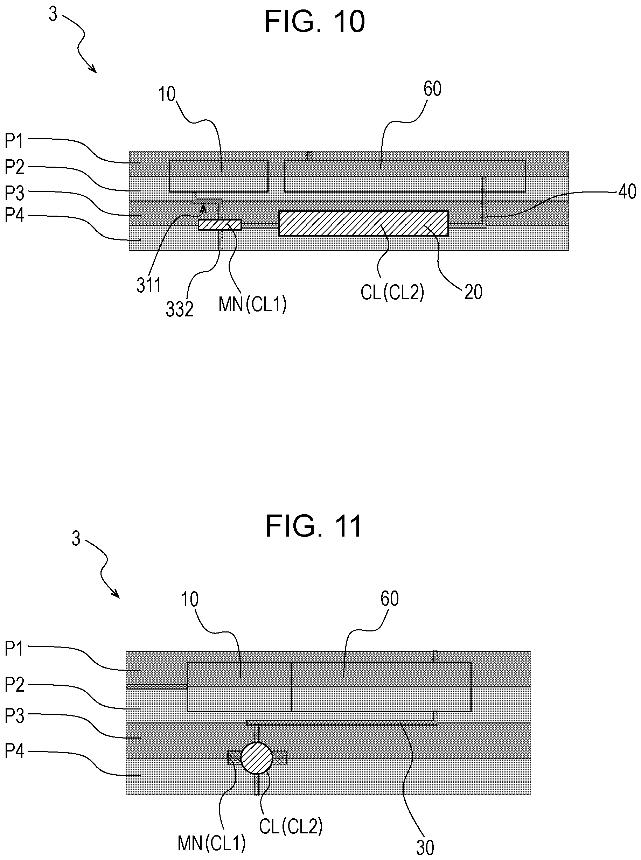

Fig. 9 is a perspective view in a state in which four plate-shaped members forming a channel structure according to a third embodiment of the present invention are separated from one another. Fig. 10 is a cross-sectional view taken along line C-C in Fig. 9. Fig. 11 is a cross-sectional view taken along line D-D in Fig. 9.

A channel structure 3 according to the third embodiment differs from the channel structure 1 according to the first embodiment for the number of plate-shaped members forming the channel structure, and in that the channel structure 3 includes a waste-liquid storage 60 and that an injection portion 31 has a hollow portion 331 capable of receiving a porous body MN.

The channel structure 3 according to the third embodiment is formed of a bonded body of four plate-shaped members P1, P2, P3, and P4. An open end 43 of the discharge channel 40 of the channel structure 3 opposite to an open end 42 connected to the other open end 22 of a separation-element housing 20 is connected to an inlet portion 62 of the waste-liquid storage 60.

The waste-liquid storage 60 can store liquid flowing from the inlet portion 62 into a hollow waste-liquid container portion 61. The waste-liquid storage 60 has a waste-liquid vent 63 causing the inside of the waste-liquid container portion 61 to communicate with the outside, and hence allowing liquid to easily flow into the waste-liquid container portion 61. The waste-liquid vent 63 may be a through hole. In this case, an opening at an exposed principal surface side of the plate-shaped member P1 may be in a completely open state, or may be provided with a film-shaped body allowing gas to pass therethough but almost inhibiting liquid from passing therethough. With such a configuration, the possibility that the liquid in the waste-liquid container portion 61 leaks out to the channel structure 3 can be decreased. The waste-liquid vent 63 may have a check valve, and a backflow of the liquid in the channel structure 3 may be prevented.

The injection portion 31 of the channel structure 3 according to the third embodiment has a hollow potion 331 capable of receiving a porous body MN, at the junction portion between a liquid-storage-side channel 31 and a separation-element-side channel 32. In the channel structure 3, the hollow portion 331 is defined by grooves of the two plate-shaped members P3 and P4. The liquid to be measured input from an opening 332 of the injection portion 31 located at an exposed principal surface of the plate-shaped member P4 is diffused in the porous body MN arranged in the hollow portion 331. Then, the liquid to be measured is mixed with the liquid flowing from the liquid-storage-side channel 31 into the porous body MN, and the obtained mixed liquid flows out to the separation-element-side channel 32.

The material forming the porous body MN is not particularly limited. As described above, a preferable example of the material may be a silica monolith. The porous body MN may have a function of promoting separation of the liquid to be measured in cooperation with a separation element housed in the separation-element housing 20. For an example of such a configuration, the porous body MN arranged in the injection portion 33 may have a function considered as pre-processing in relation to the separation element.

For another example, the porous body MN arranged in the injection portion 33 may have a function of a separation element and may configure a separation element having one function in cooperation with the separation element housed in the separation-element housing 20. As a specific example of this case, referring to Figs. 9 to 11, a first separation column CL1 may be arranged in the hollow portion 331, and a second separation column CL2 may be arranged in the separation-element housing 20. With this configuration, when the liquid to be measured is blood and a specific analyte is HbA1c, a negative-ion modified silica monolith can be used as the first separation column CL1 arranged in the injection portion 33, and a positive-ion modified silica monolith can be used as the second separation column CL2 housed in the separation-element housing 20.

### Fourth Embodiment

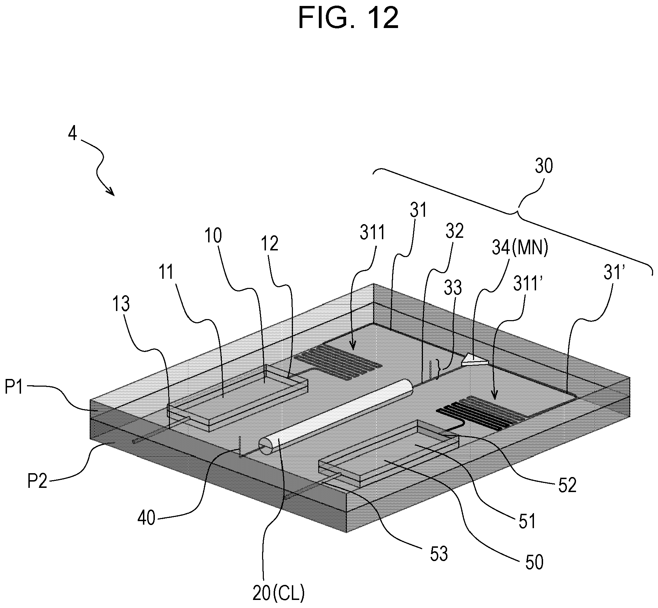

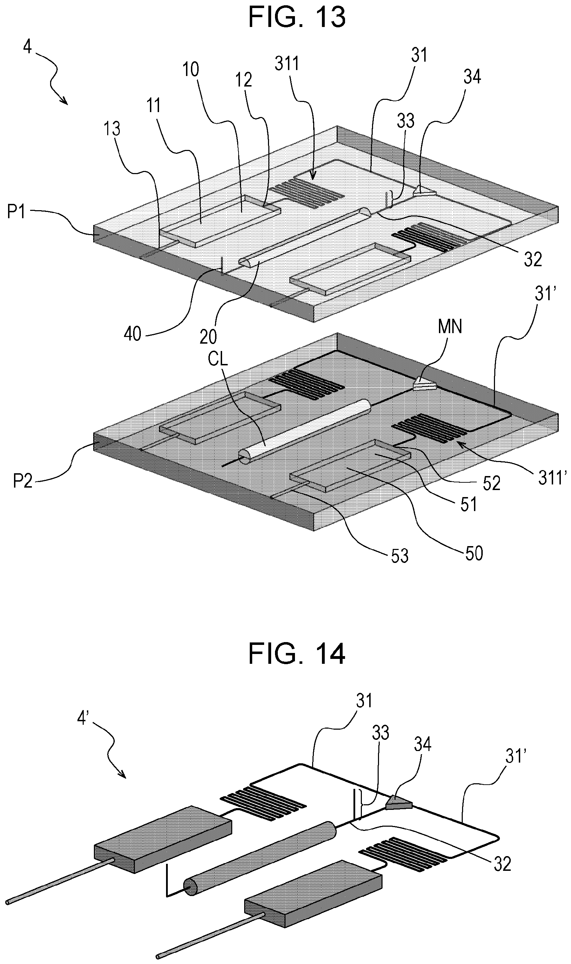

Fig. 12 is a perspective view of a channel structure according to a fourth embodiment of the present invention. Fig. 13 is a perspective view in a state in which two plate-shaped members forming the channel structure according to the fourth embodiment of the present invention are separated from one another. Fig. 14 is a perspective view illustrating only a channel part of the channel structure according to the fourth embodiment of the present invention.

A channel structure 4 according to the fourth embodiment illustrated in Figs. 12 to 14 differs from the channel structure 1 according to the first embodiment in that a plurality of liquid storages are provided, and hence the configuration of supply channels is different.

Specifically, the channel structure 4 according to the fourth embodiment includes, in addition to a liquid storage 10 (in this embodiment, referred to as "first liquid storage 10") and a liquid-storage-side channel 31 (in this embodiment, referred to as "first liquid-storage-side channel 31"), a second liquid storage 50 and a second liquid-storage-side channel 31'. The second liquid storage 50 has a liquid container portion 51, an outlet portion 52, and a pressure transmission portion 53, like the first liquid storage 10. The supply channel 31 of the channel structure 2 includes a convergence portion 34 arranged between the outlet portions 12, 52 of the plurality of liquid storages (first liquid storage 10, second liquid storage 50) and a separation-element-side channel 32, converging the plurality of liquid-storage-side channels (first liquid-storage-side channel 31, second liquid-storage-side channel 31'), and causing the plurality of liquid storages (first liquid storage 10, second liquid storage 50) to communicate with the separation-element-side channel 32.

Since the channel structure 4 according to the fourth embodiment has the above-described configuration, the type of the composition of liquid to be supplied to the separation element (separation column CL also in this embodiment) can be plural types. Specifically, liquid (first liquid) stored in the first liquid storage 10 can be supplied to the separation element (separation column CL) at the beginning of measurement, and after a predetermined period of time elapses, liquid (second liquid) stored in the second liquid storage 50 can be supplied to the separation element (separation column CL).

Also, the first liquid and the second liquid can be mixed with one another in the convergence portion 34, and the mixed liquid can be supplied to the separation element (separation column CL). When the mixed liquid is formed at the convergence portion 34 as described above, the amount of the first liquid and the amount of the second liquid to be supplied to the convergence portion 34 are adjusted. Hence, only with the two liquid storages, liquid having various compositions can be supplied to the separation element (separation column CL). Further, the amount of the first liquid and the amount of the second liquid to be supplied to the convergence portion 34 are adjusted over time. Hence, liquid having a density being continuously changed over time can be supplied to the separation element (separation column CL) .

To more properly mix the liquid from the plurality of liquid storages in the convergence portion 34, a porous body MN is arranged in the convergence portion 34 in the channel structure 4 according to the fourth embodiment. The porous body MN arranged in the convergence portion 34 is preferably made of a silica monolith.

Similarly to the porous body MN arranged in the hollow portion 331 of the injection portion 33 in the channel structure 3 according to the third embodiment, the porous body MN arranged in the convergence portion 34 may have a function of promoting separation of the liquid to be measured in cooperation with the separation element (separation column CL) arranged in the separation-element housing 20.

To more properly mix the liquid from the plurality of liquid storages (first liquid storage 10, second liquid storage 50) and to increase separation performance of the separation element (separation column C), an individual rectifying portion 311' decreasing a variation in the flow rate of the liquid flowing in the convergence portion 34 is preferably arranged between the outlet portion 52 of the second liquid storage 50 and the convergence portion 34. The individual rectifying portion 311' is equivalent, in terms of the function, to the rectifying portion 311 arranged between the outlet portion 12 of the first liquid storage 10 and the convergence portion 34. That is, the rectifying portion 311 causes the liquid from the first liquid storage 10 to be easily properly mixed with the liquid from the second liquid storage 50 in the convergence portion 34.

Fig. 14 illustrates a channel part 4' of the channel structure 4 according to the fourth embodiment.

### Modifications of Fourth Embodiment

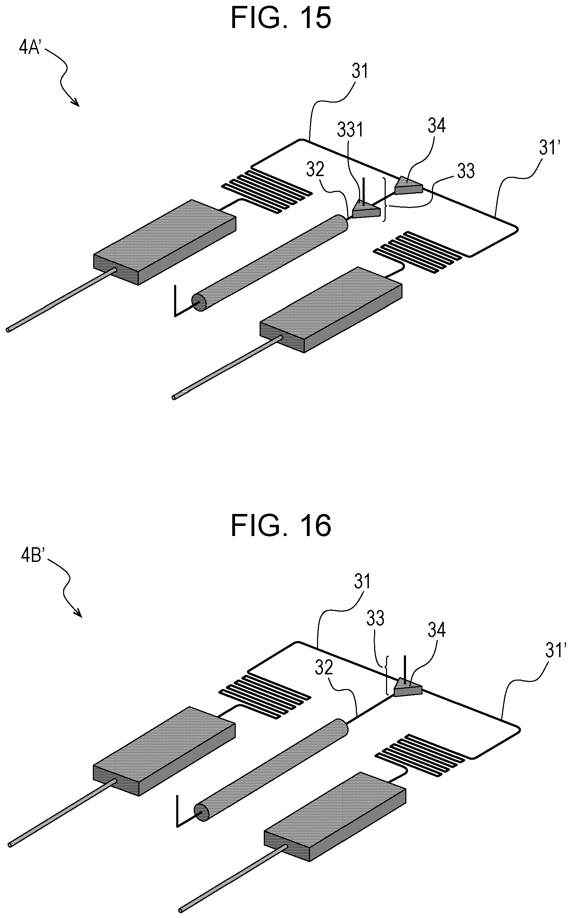

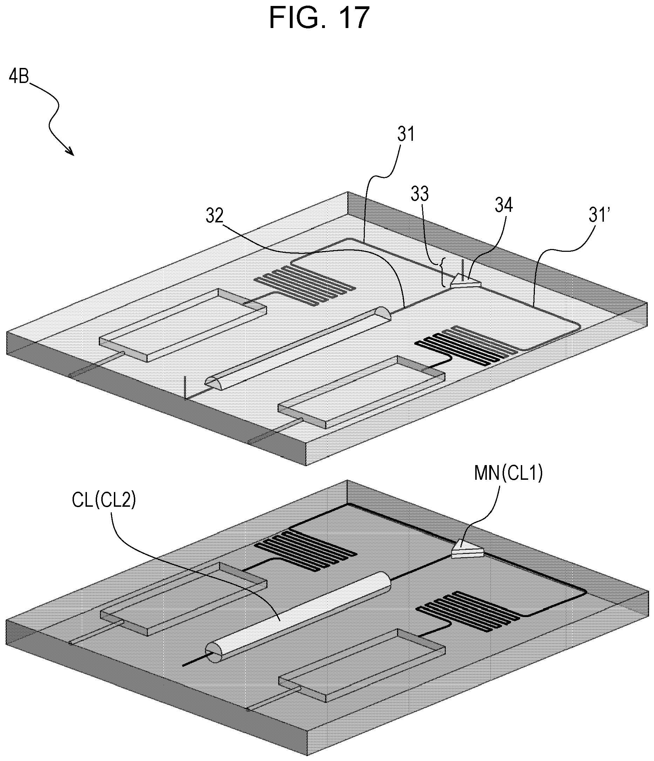

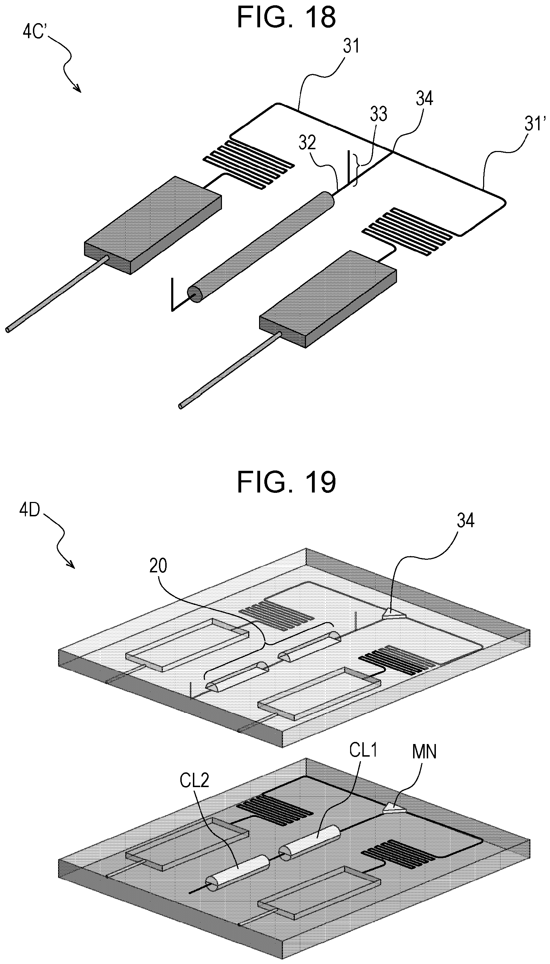

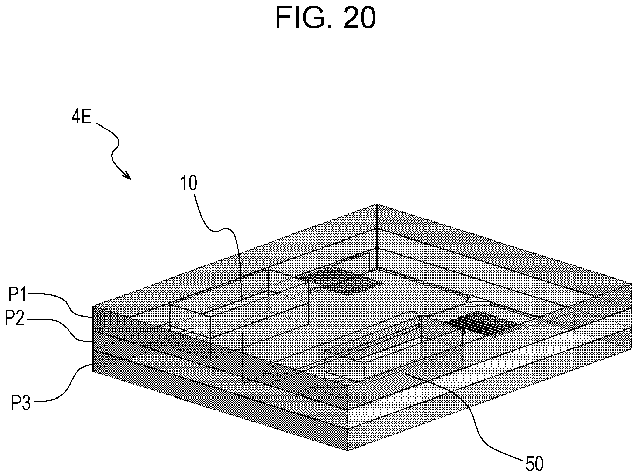

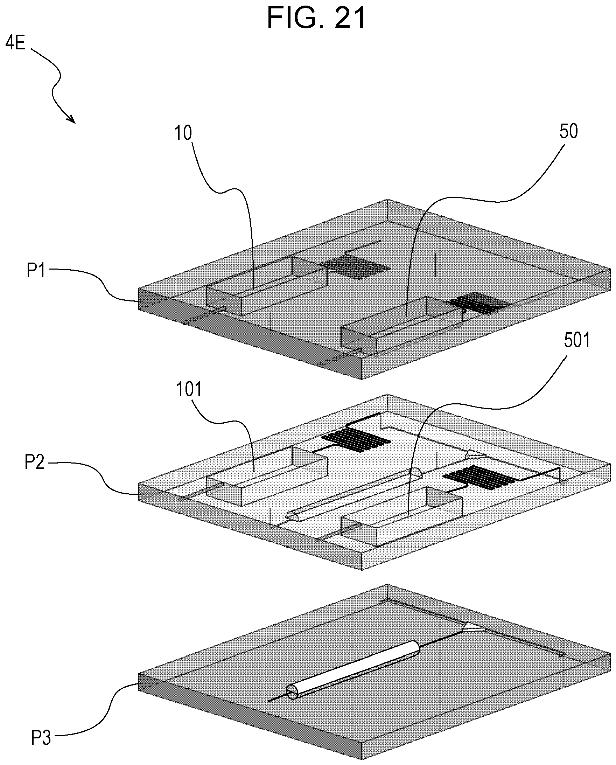

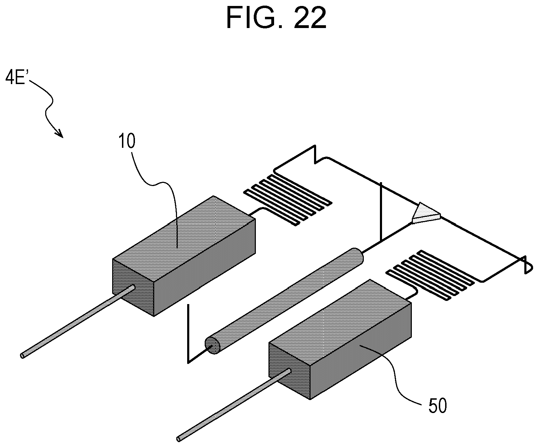

Fig. 15 is a perspective view illustrating only a channel part of a channel structure according to a modification (first modification) of the fourth embodiment of the present invention. Fig. 16 is a perspective view illustrating only a channel part of a channel structure according to another modification (second modification) of the fourth embodiment of the present invention. Fig. 17 is a perspective view in a state in which two plate-shaped members forming the channel structure according to the second modification of the fourth embodiment of the present invention are separated from one another. Fig. 18 is a perspective view illustrating only a channel part of a channel structure according to still another modification (third modification) of the fourth embodiment of the present invention. Fig. 19 is a perspective view in a state in which two plate-shaped members forming a channel structure according to yet another modification (fourth modification) of the fourth embodiment of the present invention are separated from one another. Fig. 20 is a perspective view of a channel structure according to a further modification (fifth modification) of the fourth embodiment of the present invention. Fig. 21 is a perspective view in a state in which three plate-shaped members forming the channel structure according to the fifth modification of the fourth embodiment of the present invention are separated from one another. Fig. 22 is a perspective view illustrating only a channel part of the channel structure according to the fifth modification of the fourth embodiment of the present invention.

As it is found from a channel part 4A' of the channel structure according to the first modification of the fourth embodiment illustrated in Fig. 15, in the channel structure according to the first modification of the fourth embodiment, an injection portion 33 has a hollow portion 331 capable of housing a porous body MN. Hence, with the channel structure according to the first modification of the fourth embodiment, the porous body MN is arranged in each of a convergence portion 34 and the injection portion 33. With such a configuration, the degree of mixing of the liquid flowing in the separation-element side channel 32 and supplied to the separation element can be increased. Also, the two porous bodies MN and the separation column CL in cooperation with one another may function as one separation element.

As it is found from a channel part 4B' of a channel structure according to the second modification of the fourth embodiment illustrated in Fig. 16, in a channel structure 4B according to the second modification of the fourth embodiment, an injection portion 33 is integrated with a convergence portion 34. With such a configuration, the channel structure 4B illustrated in Fig. 17 can properly mix the first liquid, the second liquid, and the liquid to be measured with one another although the channel structure 4B has a simple structure. Also in this case, a porous body MN arranged in the convergence portion 34 and a separation element (separation column CL) arranged in a separation-element housing 20 in cooperation with one another may function as one separation element (a specific example may be a configuration including a first separation column CL1 and a second separation column CL2 illustrated in Fig. 17).

As it is found from a channel part 4C' of the channel structure according to the third modification of the fourth embodiment illustrated in Fig. 18, in the channel structure according to the third modification of the fourth embodiment, a convergence portion 34 is formed of a channel having a T-shaped branch structure, and a porous body MN is not arranged in the convergence portion 34. Hence, the channel structure according to the third modification of the fourth embodiment has a simplified structure.

In a channel structure 4D according to the fourth modification of the fourth embodiment illustrated in Fig. 19, two separation elements (first separation column CL1, second separation column CL2) are arranged in a separation-element housing 20. The two separation elements (first separation column CL1, second separation column CL2) arranged in the separation-element housing 20 and the porous body MN arranged in the convergence portion 34 in cooperation with one another may function as one separation element.

A channel structure 4E according to the fifth modification of the fourth embodiment illustrated in Fig. 20 is formed of a bonded body of three plate-shaped members P1, P2, and P3. As illustrated in Fig. 21, in the plate-shaped member P2 of the channel structure 4E according to the fifth modification of the fourth embodiment, a portion defining a liquid container portion of a first liquid storage 10 is formed of a through hole 101, and a portion defining a liquid container portion of a second liquid storage 50 is formed of a through hole 501. Hence, in the channel structure 4E, the liquid container portion of the first liquid storage 10 and the liquid container portion of the second liquid storage 50 have larger volumes than those of the channel structure 4 according to the fourth embodiment. Accordingly, as it is found from a channel part 4E' of the channel structure illustrated in Fig. 22, the channel structure 4E can store the first liquid and the second liquid by larger amounts than those of the channel structure 4.

A measurement unit can be obtained by storing liquid (a specific example may be a developing solution or a cleaning solution) in the liquid container portion of the liquid storage of the channel structure according to any one of the above-described embodiments of the present invention. The measurement unit can start measurement on liquid to be measured by only setting the measurement unit in a device.

As a specific example of the above-described measurement unit, an example of a method of measuring liquid to be measured by using the measurement unit in which liquid (a specific example is a developing solution) is described below is stored in the liquid container portion of the liquid storage of the channel structure according to any one of the above-described embodiments of the present invention.

First, an external force is applied to the pressure transmission portion, liquid in the liquid container portion of the measurement unit is supplied to the supply channel, and an area extending to the discharge channel is filled with the liquid. The measurement unit may include such a configuration (the state in which the area from the supply channel to the discharge channel is filled with the liquid in the liquid container portion) in advance. Then, liquid to be measured is input to the injection portion of the measurement unit. Consequently, mixed liquid of the liquid supplied from the inside of the liquid container portion and the liquid to be measured is formed in the injection portion. Then, an external force is applied to the pressure transmission portion, a developing solution in the liquid container portion is supplied into the supply channel, the mixed liquid formed in the injection portion is supplied to the separation element, and an element to be measured is separated. Then, the liquid passing through the separation element is measured, and information on the composition of the liquid to be measured is obtained.

The channel structure in the measurement unit is a bounded body of a plurality of plate-shaped members. At least one of the plurality of plate-shaped base members preferably transmit measurement light in a wavelength range emitted for measuring the liquid to be measured. In this case, by irradiating the liquid containing the liquid to be measured passing through the separation element and located in the discharge channel, with the measurement light, the information on the composition of the liquid to be measured can be obtained.

The separation element may be a separation column. In this case, the pressure of the liquid (supply pressure) to be supplied to the separation column is preferably 1 MPa or lower to easily configure a device (measurement device) in which the measurement unit is incorporated and to promote reduction in size of the measurement device. If the separation column is made of a silica monolith, it is easy to set the supply pressure at 1 MPa or lower. If the separation column is made of an aggregate of resin particles (polymer beads), it is difficult to set the supply pressure at 1 MPa or lower.

A specific configuration of the above-described measurement device is appropriately set in accordance with the configuration of the measurement unit, the type of liquid to be measured, and so forth.

The above-described embodiments are described for easier understanding of the present invention, and are not described for limiting the present invention. Therefore, the elements disclosed in the above-described embodiments include all design changes and equivalents pertaining to the technical scope of the present invention.

For example, the pressure transmission portion may have a direct-acting structure, and the pressure in the liquid storage can be increased by a force applied from outside the channel structure to the direct-acting structure. With such a configuration, if a device having incorporated therein the channel structure has a driving system for moving the direct-acting mechanism, the liquid can be circulated in the separation element.

The separation element may be an electric migration element. In this case, the channel structure has an electrode portion in a channel, and the electrode portion can be electrically connected to the measurement device.

The channel structure 4 according to the fourth embodiment includes the first liquid storage 10 and the second liquid storage 50, and hold liquid (for example, for 100 times of use) required for such a plurality of liquid storages (first liquid storage 10, second liquid storage 50) in terms of the unit of the number of times of use for each of the liquid storages. Additionally, the structure may include another tank for storing liquid for one time of use. By decreasing the load of sending the liquid, mixing can be controlled by a further fine amount.

### Industrial Applicability

A channel structure according to the present invention is suitable for a channel structure incorporated in a measurement device realizing POCT for HbAlc etc. as a specific measurement object. A measurement unit including the channel structure according to the present invention can perform measurement without supply of liquid from the outside except for liquid to be measured, and hence the measurement device can be reduced in size.

### Reference Signs List

1, 1A, 2, 3, 4, 4B, 4D, 4E channel structure
1', 4', 4A', 4B', 4C', 4E' channel part of channel structure
P1, P2, P3, P4 plate-shaped member
10 liquid storage (first liquid storage)
   11 liquid container portion
   12 outlet portion
   13 pressure transmission portion
20 separation-element housing
   21, 22 open end of separation-element housing 20
   CL separation column
   CL1 first separation column
   CL2 second separation column
30 supply channel
   31 liquid-storage-side channel (first liquid-storage-side channel)
   31' second liquid-storage-side channel
   311 rectifying portion
   311' individual rectifying portion
   32 separation-element-side channel
   33 injection portion
   MN porous body
   331 hollow portion
   332 opening
   34 convergence portion
40 discharge channel
   41 measurement channel portion
   42, 43 open end
50 second liquid storage
   51 liquid container portion
   52 outlet portion
   53 pressure transmission portion
60 waste-liquid storage
   61 waste-liquid container portion
   62 inlet portion
   63 waste-liquid vent
101, 501 through hole

## Claims

1. A channel structure comprising a liquid storage having a liquid container portion capable of storing liquid and an outlet portion, a separation-element housing having arranged therein a separation element between two open ends thereof, a supply channel connected to the outlet portion of the liquid storage and the one open end of the separation-element housing and causing the liquid storage and the separation-element housing to communicate with one another, and a discharge channel connected to the other open end of the separation-element housing,
wherein the supply channel includes a liquid-storage-side channel connected to the outlet portion of the liquid storage, a separation-element-side channel connected to the separation-element housing, and an injection portion located between the liquid-storage-side channel and the separation-element-side channel and being capable of introducing liquid to be measured into the supply channel, and
wherein the liquid storage includes a pressure transmission portion capable of transmitting an external force applied to the channel structure, as a variation in a pressure in the liquid storage, and is capable of causing liquid stored in the liquid storage to flow out from the outlet portion to the supply channel on the basis of the variation in the pressure in the liquid storage.

2. The channel structure according to claim 1, wherein the channel structure is formed of a bonded body of a plurality of plate-shaped base members.

3. The channel structure according to claim 1 or 2, wherein the pressure transmission portion is a tubular body communicating with the inside of the liquid storage and the outside of the channel structure, and the pressure in the liquid storage can be increased by a pressure of a fluid to be supplied from outside the channel structure into the tubular body.

4. The channel structure according to any one of claims 1 to 3, wherein the pressure transmission portion has a direct-acting structure, and the pressure in the liquid storage can be increased by a force applied from outside the channel structure to the direct-acting structure.

5. The channel structure according to any one of claims 1 to 4, wherein the separation element is a separation column.

6. The channel structure according to any one of claims 1 to 4, wherein the separation element is an electric migration element.

7. The channel structure according to any one of claims 1 to 6, wherein an input portion capable of inputting liquid into the liquid container portion of the liquid storage is provided.

8. The channel structure according to any one of claims 1 to 7, wherein a vent capable of discharging gas in the liquid container portion of the liquid storage is provided.

9. The channel structure according to any one of claims 1 to 8, wherein a porous body promoting mixing of the liquid to be measured with liquid from the liquid storage is arranged in the injection portion.

10. The channel structure according to claim 9, wherein the porous body arranged in the injection portion has a function of promoting separation of the liquid to be measured in cooperation with the separation element.

11. The channel structure according to any one of claims 1 to 10, further comprising a rectifying portion arranged at the liquid-storage-side channel and decreasing a variation in a flow rate of liquid flowing in the injection portion.

12. The channel structure according to any one of claims 1 to 11, wherein a plurality of the liquid storages and a plurality of the liquid-storage-side channels connected to the plurality of liquid storages are provided, and the supply channel includes a convergence portion arranged between outlet portions of the plurality of liquid storages and the separation-element-side channel, converging the plurality of liquid-storage-side channels, and causing the plurality of liquid storages to communicate with the separation-element-side channel.

13. The channel structure according to claim 12, wherein a porous body promoting mixing of liquid from the plurality of liquid storages is arranged in the convergence portion.

14. The channel structure according to claim 13, wherein the porous body arranged in the convergence portion has a function of promoting separation of the liquid to be measured in cooperation with the separation element.

15. The channel structure according to any one of claims 12 to 14, further comprising an individual rectifying portion arranged between the outlet portion and the convergence portion and decreasing a variation in a flow rate of liquid flowing in the convergence portion.

16. The channel structure according to any one of claims 12 to 15, wherein the injection portion is integrally provided with the convergence portion.

17. The channel structure according to any one of claims 1 to 16, further comprising a waste-liquid storage connected to an open end of the discharge channel opposite to an open end of the discharge channel connected to the separation-element housing, and storing liquid passing through the separation element.

18. The channel structure according to claim 17, wherein the waste-liquid storage has a vent discharging gas in the waste-liquid storage.

19. The channel structure according to any one of claims 2 to 18,
wherein at least one of the plurality of plate-shaped base members forming the bonded body transmits measurement light in a wavelength range emitted for measuring the liquid to be measured, and
wherein the discharge channel includes a channel portion extending in a thickness direction of the bonded body.

20. The channel structure according to any one of claims 2 to 19, wherein a distance between a portion of the liquid container portion of the liquid storage being the closest to one of principal surfaces of the bonded body and the one of the principal surfaces of the bonded body is smaller than a distance between a portion of the separation-element housing being the closest to the one of the principal surfaces of the bonded body and the one of the principal surfaces of the bonded body.

21. The channel structure according to any one of claims 2 to 20, wherein the plate-shaped base members are three or more plate-shaped base members.

22. The channel structure according to claim 21,
wherein the liquid storage is formed by removing a portion of at least two of the plate-shaped base members, and the separation-element housing is formed by removing a portion of at least two of the plate-shaped base members, and
wherein the at least two of the plate-shaped members forming the liquid storage are different from the at least two of the plate-shaped members forming the separation-element housing.

23. A measurement unit comprising:
the channel structure according to any one of claims 2 to 22; and
liquid stored in the liquid container portion of the channel structure.

24. A method of measuring liquid to be measured comprising:
inputting liquid to be measured to the injection portion of the measurement unit according to claim 23;
applying an external force to the pressure transmission portion, supplying a developing solution in the liquid container portion into the supply channel, and causing liquid containing the liquid to be measured to pass through the inside of the separation element; and
measuring liquid containing the liquid to be measured passing through the separation element, and obtaining information on a composition of the liquid to be measured.

25. The method of measuring liquid to be measured according to claim 24,
wherein at least one of the plurality of plate-shaped base members forming the bonded body transmits measurement light in a wavelength range emitted for measuring the liquid to be measured, and
wherein the information on the composition of the liquid to be measured is obtained by irradiating liquid containing the liquid to be measured passing through the separation element and located in the discharge channel, with the measurement light.

26. The method of measuring liquid to be measured according to claim 24 or 25, wherein the separation element is a separation column, and a pressure of liquid to be supplied to the separation column is 1 MPa or lower.

27. A measurement device for liquid to be measured comprising the measurement unit according to claim 23.
